(19) **Europäisches Patentamt / European Patent Office / Office européen des brevets**

(11) **EP 2 869 351 A2**

(12) # EUROPEAN PATENT APPLICATION

(43) Date of publication:
**06.05.2015 Bulletin 2015/19**

(51) Int Cl.:
**H01L 31/0224** (2006.01)  **H01L 31/032** (2006.01)
**H01L 31/0749** (2012.01)

(21) Application number: **14170675.4**

(22) Date of filing: **30.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.10.2013 KR 20130131683**

(71) Applicant: **Samsung SDI Co., Ltd.**
**Yongin-si, Gyeonggi-do (KR)**

(72) Inventor: **Jung, Seung-Jae**
**Gyeonggi-do (KR)**

(74) Representative: **Taor, Simon Edward William et al**
**Venner Shipley LLP**
**200 Aldersgate**
**London EC1A 4HD (GB)**

(54) **Solar cell and a manufacturing method thereof**

(57) A solar cell according to embodiments of the present invention includes: a substrate; a first electrode formed on the substrate; a photoactive layer formed on the first electrode and including group I and III elements; and a second electrode formed on the photoactive layer. The first electrode includes first and second parts respectively having different resistivity, and group I to group III element composition ratios of the photoactive layer respectively corresponding to the first and second parts are different from each other.

EP 2 869 351 A2

**Description**

The described technology relates to a solar cell including a CIS/CIGS-based semiconductor, and a manufacturing method thereof.

A solar cell is a photoelectric conversion element which converts solar energy into electrical energy, and it has recently drawn attention as a substantially limitless nonpolluting next generation energy source.

The solar cell usually includes a p-type semiconductor and an n-type semiconductor, and can be used as an external electrical energy source that absorbs solar light energy into a photoactive layer to generate electron-hole pairs (EHPs) in the semiconductor, such that the generated electrons and holes move respectively to the n-type semiconductor and the p-type semiconductor to be collected in the electrodes.

A compound semiconductor including group I-III-VI elements may be used as the photoactive layer.

The compound semiconductor may have a high light absorption coefficient and high electro-optic stability, and thus a solar cell having high efficiency may be embodied.

However, when forming the compound semiconductor, ratios of respective elements may be drastically changed inside as well as on the surface of the photoactive layer due to reactivity differences between the elements.

In this case, the resulting photoactive layer may be formed as a thin film having greatly different constitutive elements depending on their positions, and the efficiency of the solar cell may be deteriorated as a result.

In addition, when soda-lime glass is used as a substrate, sodium (Na) included in the substrate is diffused into the photoactive layer, thereby affecting the efficiency of the solar cell.

The amount of sodium (Na) diffused into the photoactive layer may depend on resistivity of an electrode positioned between the substrate and the photoactive layer, and the amount of sodium (Na) to be diffused increases as the resistivity of the electrode increases.

The above information disclosed in this Background section is only for enhancement of understanding of the background of the described technology and therefore it may contain information that does not form the prior art that is already known in this country to a person of ordinary skill in the art.

As a substrate becomes larger, resistivity of an electrode may vary depending on a position on the substrate, and thus the amount of sodium (Na) diffused into a photoactive layer may vary according to the resistivity, thereby deteriorating efficiency of a solar cell.

Aspects of embodiments of the described technology are directed toward a solar cell and a manufacturing method thereof capable of having uniform efficiency even if resistivity differences in the substrate are induced due to a larger area of the substrate.

A solar cell according to an embodiment of the present invention includes: a substrate; a first electrode formed on the substrate; a photoactive layer formed on the first electrode and including group I and group III elements; and a second electrode formed on the photoactive layer, wherein the first electrode includes first and second parts respectively having different resistivity, and group I to group III element composition ratios in regions of the photoactive layer respectively corresponding to the first and second parts are different from each other.

The resistivity of the first part may be higher or lower than the average resistivity of the first electrode.

When resistivity of the first part is higher than the average resistivity of the first electrode, a group I to group III element composition ratio in regions of the photoactive layer corresponding to the first part may be smaller than the average group I to group III element composition ratio of the photoactive layer, and when resistivity of the first part is lower than the average resistivity of the first electrode, the group I to group III element composition ratio in regions of the photoactive layer corresponding to the first part may be larger than the average group I to group III element composition ratio of the photoactive layer.

The resistivity of the first part may be higher than the average resistivity of the first electrode by at least 5 percent, and the group I to group III element composition ratio in regions of the photoactive layer corresponding to the first part may be smaller than the average group I to group III element composition ratio of the photoactive layer by at least 0.01.

The difference between the resistivity of the second part and the average resistivity of the first electrode may be less than 5 percent.

The resistivity of the first part may be lower than the average resistivity of the first electrode by at least 5 percent, and the group I to group III element composition ratio in regions of the photoactive layer corresponding to the first part may be larger than the average group I to group III element composition ratio of the photoactive layer by at least 0.01.

The difference between the resistivity of the second part and the average resistivity of the first electrode may be less than 5 percent.

The group I to group III element composition ratio Y may satisfy the following Equation 1.

## Equation 1

$$Y = -0.0104X + 1.1226$$

(X is the resistivity of the first electrode)

The group I element may be copper (Cu), silver (Ag), or gold (Au), and the group III element may be indium (In) or gallium (Ga).

The first electrode may be made of molybdenum (Mo).

An embodiment of the present invention provides a manufacturing method of a solar cell, including: forming a first electrode on a substrate; forming a photoactive layer including group I and group III elements on the first electrode; and forming a second electrode on the photoactive layer. A group I to group III element composition ratio of the photoactive layer varies according to the resistivity of the first electrode.

The first electrode may include a first part having higher resistivity than the average resistivity of the first electrode by at least 5 percent, and the group I to group III element composition ratio in regions of the photoactive layer corresponding to the first part may be smaller than the average group I to group III element composition ratio of the photoactive layer by at least 0.01.

The first electrode may include a first part having lower resistivity than the average resistivity of the first electrode by at least 5 percent, and the group I to group III element composition ratio in regions of the photoactive layer corresponding to the first part may be larger than the average group I to group III element composition ratio of the photoactive layer by at least 0.01.

The group I to group III element composition ratio Y may be calculated from Equation 1.

## Equation 1

$$Y = -0.0104X + 1.1226$$

(X is the resistivity of the first electrode)

The photoactive layer may formed by a sputtering method or an evaporation method.

The photoactive layer may include a first thin film including group I and III elements and a second thin film including a group III element. When the first part of the first electrode has higher resistivity than the average resistivity of the first electrode by at least 5 percent, the thickness of a region of the first thin film corresponding to the first part may be smaller than that of a region of the first thin film corresponding to a part of the first electrode having lower resistivity than the average resistivity of the first electrode by at most 5 percent, and the thickness of a region of the second thin film corresponding to the first part may be larger than that of a region of the second thin film corresponding to the part of the first electrode having lower resistivity than the average resistivity of the first electrode by at most 5 percent.

The photoactive layer may include a first thin film including group I and III elements and a second thin film including a group III element. When the first part of the first electrode has lower resistivity than the average resistivity of the first electrode by at least 5 percent, the thickness of a region of the first thin film corresponding to the first part may be larger than that of a region of the first thin film corresponding to a part of the first electrode having lower resistivity than the average resistivity of the first electrode by at most 5 percent, and the thickness of a region of the second thin film corresponding to the first part may be smaller than that of a region of the second thin film corresponding to the part of the first electrode having lower resistivity than the average resistivity of the first electrode by at most 5 percent.

The group I element may be copper (Cu), silver (Ag), or gold (Au), and the group III element may be indium (In) or gallium (Ga).

According to an aspect of the invention, there is provided a solar cell as set out in claim 1. Preferred features are set out in claims 2 to 8.

According to an aspect of the invention, there is provided a method of manufacturing method of a solar cell as set out in claim 9. Preferred features are set out in claims 10 to 15.

When the solar cell is formed according to the embodiments of the present invention and using the manufacturing method thereof, the resulting solar cell may be capable of having uniform efficiency without regions of deteriorated efficiency.

FIG. 1 is a schematic cross-sectional view of a solar cell according to one embodiment.

FIG. 2 is a graph of conversion efficiency measured according to variations of group I to group III element composition ratios when the resistivity of molybdenum is 20.5Ω, 23.4Ω, and 25.3Ω, respectively.

FIG. 3 is a graph showing the resistivity of molybdenum at desired group I to group III element composition ratios.

FIGS. 4 to 6 are cross-sectional views of the solar cell at different steps in the manufacturing process according to one embodiment.

The present invention will be described more fully hereinafter with reference to the accompanying drawings, in which exemplary embodiments of the invention are shown.

As those skilled in the art would realize, the described embodiments may be modified in various different ways, all without departing from the scope of the present invention. In the drawings, the thickness of layers, films, panels, regions, etc., are exaggerated for clarity.

Like reference numerals designate like elements throughout the specification.

It will be understood that when an element such as a layer, film, region, or substrate is referred to as being "on" another element, it can be directly on the other element or intervening elements may also be present.

In contrast, when an element is referred to as being "directly on" another element, there are no intervening elements present.

Further, the use of "may" when describing embodiments of the present invention refers to "one or more embodiments of the present invention."

Hereinafter, a solar cell will be described in detail with reference to the drawings.

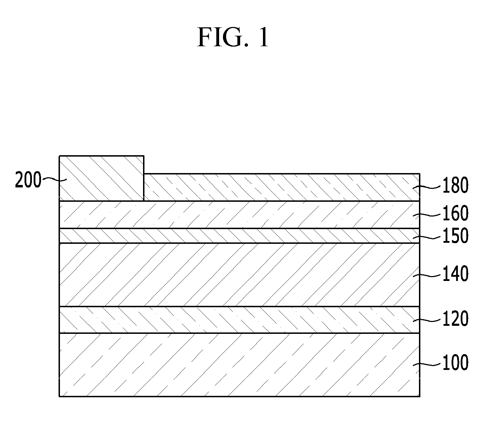

FIG. 1 is a schematic cross-sectional view of a solar cell according to one embodiment.

As shown in FIG. 1, the solar cell according to the present invention includes: a substrate 100; a first electrode 120 formed on the substrate 100; a photoactive layer 140 formed on the first electrode 120; a buffer layer 150 formed on the photoactive layer 140; a second electrode 160 formed on the buffer layer 150; an anti-reflection layer 180 formed on the second electrode 160; and a grid electrode 200 connected to the second electrode 160.

The substrate 100 may have an insulating property and may be made of soda-lime glass.

Since soda-lime glass contains a large amount of sodium (Na), the sodium may be diffused into the photoactive layer through the first electrode during a deposition process of the photoactive layer at a high temperature.

The first electrode 120 may be formed of a metal having a heat resisting property, an excellent electrical contact characteristic with the material forming the photoactive layer, excellent electrical conductivity, and excellent interface cohesion with the substrate 100, for example, molybdenum (Mo).

Different regions of the first electrode 120 may have different resistivity depending on the position of the first electrode 120 relative to the substrate 100. In some embodiments, the first electrode 120 includes a first part having higher or lower resistivity than the average resistivity of the first electrode 120 and a second part having the same resistivity as the average resistivity of the first electrode 120

The first part may be positioned closer to the edges of the substrate 100, and the resistivity of the first electrode 120 may gradually increase or decrease towards the edges. In other words, depending on the circumstance, different regions of the first electrode 120 on the substrate 100 can have different resistivities. For example, a region of the first electrode 120 close to an edge of the substrate 100 can have a different resistivity to a region of the first electrode 120 away from an edge of the substrate 100.

When a solar cell becomes larger, it becomes difficult for the molybdenum, the material for the first electrode in this embodiment, to be formed uniformly. Thus, the resistivity may vary according to the change of the composition ratio of the molybdenum.

Hence, the resistivity of a molybdenum first electrode will vary according to its position of the substrate. Resistivity values of molybdenum first electrodes according to position can be measured in various ways. Furthermore, the resistivity of a given molybdenum first electrode can be estimated based on previous measurements.

The width of the first part may be no greater than 100 mm extending inwards starting from the ends of the substrate 100.

The photoactive layer 140 as a p-type CIS/CIGS based semiconductor may contain selenium (Se) or sulfur (S).

For example, the photoactive layer 140 may be $Cu(In_{1-x},Ga_x)(Se_{1-x},S_x)$ as a group I-III-VI-based semiconductor compound, wherein $0 \leq x \leq 1$.

The photoactive layer 140 may have a single phase in which the composition of the compound semiconductor is substantially uniform.

For example, it may be $CuInSe_2$, $CuInS_2$, $Cu(In,Ga)Se_2$, $(Ag,Cu)(In,Ga)Se_2$, $(Ag,Cu)(In,Ga)(Se,S)_2$, $Cu(In,Ga)(Se,S)_2$, or $Cu(In,Ga)S_2$.

In some embodiments, the photoactive layer 140 may include sodium (Na) diffused from the substrate 100.

A group I to group III element composition ratio of the photoactive layer (a ratio of group I atomic numbers to group III atomic numbers) may vary according to the resistivity of the first electrode 120, and the group I to group III element composition ratios of the regions of the photoactive layer corresponding to the first and second parts of the first electrode 120 may be different from each other.

In some embodiments, the average resistivity of the first electrode 120 is equal to an average value of resistivity of a metal layer for forming the first electrode 120 measured at 30 mm intervals.

The group I to group III element composition ratio in regions of the photoactive layer 140 corresponding to the second part of the first electrode 120 may differ from the average group I to group III element composition ratio of the photoactive layer 140 by at most 5 percent, and the group I to group III element composition ratio of the photoactive layer 140 corresponding to the first part of the first electrode 120 may differ from the average group I to group III element composition ratio of the photoactive layer 140 by more than or less than 5 percent.

When the resistivity of the first part of the first electrode 120 is higher than the average resistivity of the first electrode 120 by at least 5 percent, the group I to group III element composition ratio in regions of the photoactive layer 140 corresponding to the first part is smaller than the average group I to group III element composition ratio of the photoactive layer 140 by at least 0.01.

In contrast, when the resistivity of the first part of the first electrode 120 is lower than the average resistivity of the first electrode 120 by at least 5 percent, the group I to group III element composition ratio in regions of the photoactive layer 140 corresponding to the first part is larger than the group I to group III average element composition ratio of the photoactive layer 140 by at least 0.01.

The group I to group III element composition ratio Y of the photoactive layer 140 relative to the resistivity X of the first electrode 120 may be calculated from the following Equation 1.

$$\text{Equation 1}$$

$$Y=-0.0104X+1.1226$$

In one embodiment, when the group I to group III element composition ratio of the photoactive layer 140 is varied according to the resistivity of the first electrode 120, the efficiency of the solar cell may be improved.

In a related solar cell, since the amount of sodium (Na) diffused into the photoactive layer varies according to the resistivity of the first electrode, the efficiency of the solar cell is deteriorated in those regions of the photoactive layer, which receive higher amounts of sodium (Na).

This is because the group I to group III element composition ratio of the photoactive layer in a related solar cell is fixed regardless of the amount of diffused sodium (Na).

In contrast, in the embodiments of the present invention, the group I to group III element composition ratio of the photoactive layer 140 may vary according to the resistivity of the first electrode 120.

Accordingly, even if the amount of sodium (Na) diffused into the photoactive layer 140 varies according to the resistivity of the first electrode 120, regions having deteriorated efficiency are not formed as the group I to group III element composition ratio of the photoactive layer also varies according to the resistivity of the first electrode 120.

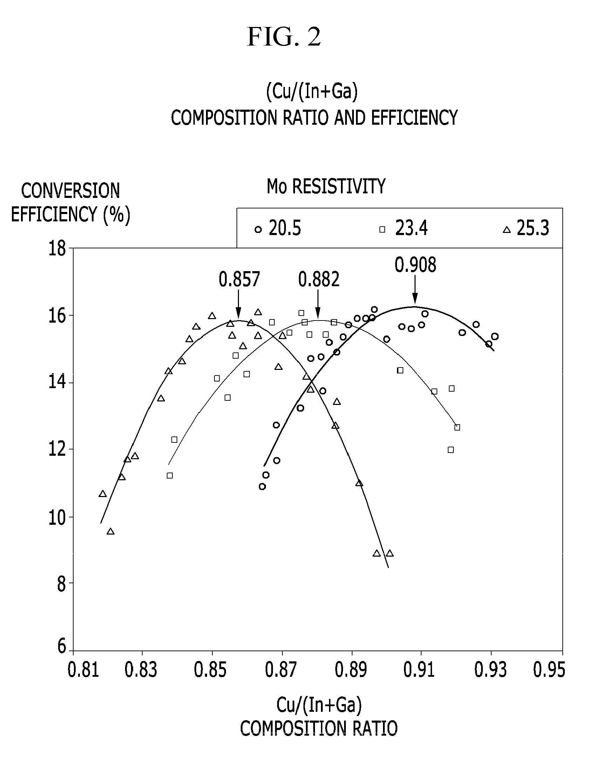

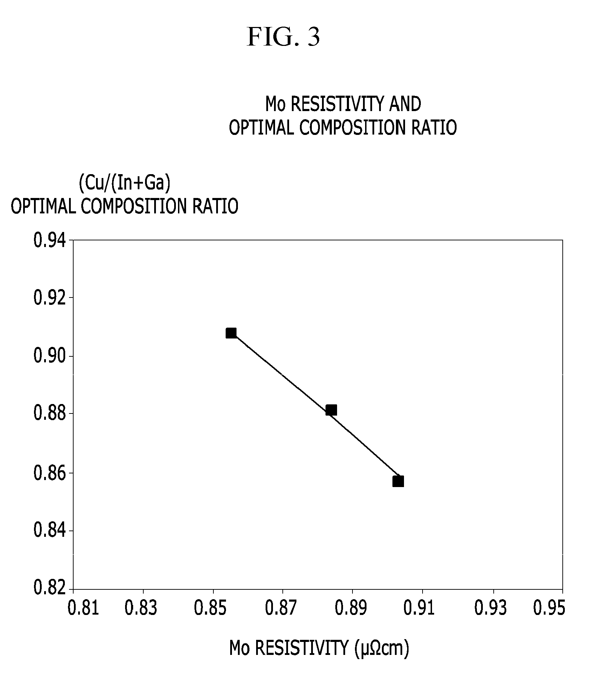

In some embodiments, Equation 1 may be derived from the data in FIG. 2 and FIG. 3, which will be described later.

FIG. 2 is a graph of conversion efficiency of the photoactive layer measured relative to variations of group I to group III element composition ratios, when the resistivity of molybdenum is 20.5Ω, 23.4 Ω, and 25.3 Ω, respectively, and FIG. 3 is a graph showing the resistivity of molybdenum at desired group I to group III element composition ratio values listed in FIG. 2.

Referring to FIG. 2, the conversion efficiency of the photoactive layer increases and then decreases as the group I to group III composition ratio value is increased.

In the present embodiment, the graphs of the group I to group III composition ratio value and the conversion efficiency are different for different resistivity values of molybdenum.

As shown in FIG. 2, when the resistivity of molybdenum is 20.5, 23.4, or 25.3, the group I to group III element composition ratios of the photoactive layer at which maximum conversion efficiency is achieved may be 0.908, 0.882, or 0.857, respectively.

As illustrated in FIG. 3, the group I to group III element composition ratios and the resistivity of molybdenum are linearly and inversely proportional. The linear graph in FIG. 3 may be used to obtain Equation 1.

In some embodiments, a difference may exist between the group I to group III composition ratio value measured in FIG. 3 and the group I to group III composition ratio value calculated from Equation 1, but the difference is at most 0.003 (e.g. not greater than 0.003), which may be regarded as a negligible value by those skilled in the art.

Referring to FIG. 1, in some embodiments the buffer layer 150 compensates for the energy gap between the photoactive layer 140 and the second electrode 160.

The buffer layer 150 is made of an n-type semiconductor material, for example, CdS, ZnS, or InS.

The second electrode 160 may be made of a material having high light transmittance and excellent conductivity, for example, ZnO having light transmittance of 80 percent or higher.

In some embodiments, a low resistance of the ZnO layer may be obtained by doping the ZnO layer with aluminum (Al) or boron (B).

The ZnO layer may be further laminated with an ITO layer having an excellent electro-optical property, or may be formed as a single ITO layer.

The ZnO layer may be further laminated with a low resistance n-type ZnO layer on an undoped n-type ZnO layer.

In one embodiment, the second electrode 160 is an n-type semiconductor, and forms a p-n junction with a p-type semiconductor such as the photoactive layer.

The anti-reflection layer 180 may improve the efficiency of the solar cell by reducing loss of incident sunlight due to reflection, but such layer may be omitted depending on the case.

In one embodiment, the anti-reflection layer 180 is made of MgF2.

In the embodiments where the anti-reflection layer 180 is formed, the grid electrode 200 is formed at one end of the anti-reflection layer 180 and contacts the second electrode 160. The grid electrode 200 collects current from a surface of the solar cell.

The grid electrode 200 may be made of aluminum (Al), nickel (Ni), or alloys thereof, but may be omitted depending on the case.

When the first and second electrodes of the solar cell according to the embodiments of the present invention are connected, current is generated and the generated current is collected by the grid electrode.

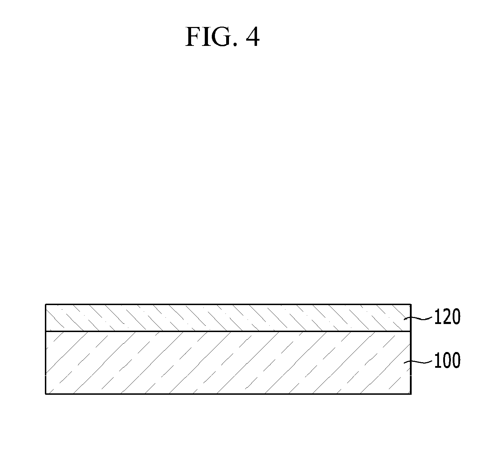

A manufacturing method of a solar cell according to some embodiments of the present invention will be described in detail, hereinafter, with reference to FIG. 1 described above, together with FIGS. 4 to 6.

FIGS. 4 to 6 are cross-sectional views of the solar cell at different acts in the manufacturing process according to one embodiment.

Referring to FIG. 4, a first electrode 120 is formed on a substrate 100 made of molybdenum (Mo), by a sputtering method.

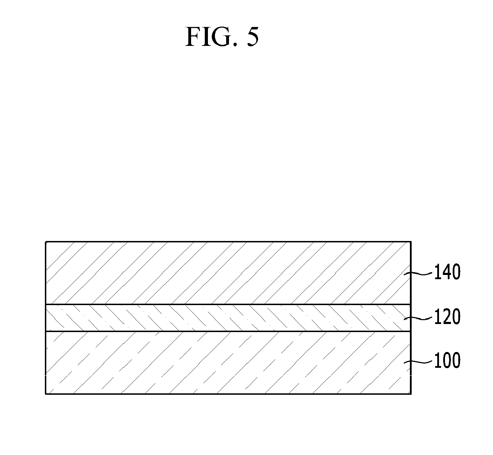

Next, as shown in FIG. 5, a photoactive layer 140 is formed on the first electrode 120.

In one embodiment, group I to group III element composition ratios of the photoactive layer 140 are configured to be different according to the resistivity of the first electrode 120.

In some embodiments, the group I element may be copper (Cu), and the group III element may be indium (In) or gallium (Ga).

The group I to group III element composition ratio Y of the photoactive layer 140 may be calculated from Equation 1.

After calculating the group I to group III element composition ratio from Equation 1, the photoactive layer 140 is formed by a combination of a sputtering method and a selenization method or an evaporation method according to the calculated ratio.

In the embodiments where a combination of the sputtering and selenization methods is utilized, the sputtering and selenization methods sequentially form a first thin film including group I and III compounds, and a second thin film including a group III element, with a sputtering device.

In this case, the first and second thin films are precursor thin films for forming the photoactive layer.

The second thin film may be formed before forming the first thin film depending on the case, and the first and second thin films may be repeatedly layered while being alternately arranged.

The group I element may be copper (Cu), silver (Ag), gold (Au), or a combination thereof, and the group III elements may be indium (In), gallium (Ga), or a combination thereof.

The respective group III elements of the first and second thin films may be different. For example, the group III element of the first thin film may be gallium (Ga) and the group III element of the second thin film may be indium (In).

In one embodiment, the group I element may be copper (Cu).

In some embodiments, the group I to group III element composition ratio in the photoactive layer is varied according to the resistivity of the first electrode by varying the respective thicknesses of the first and second thin films.

A first part of the first electrode is a part of the first electrode having higher or lower resistivity than the average resistivity of the first electrode by at least 5 percent.

In embodiments where the resistivity of the first part is higher than the average resistivity of the first electrode by at least 5 percent, the group I to group III element composition ratio of the photoactive layer is configured to be less than 1 (i.e. the amount of group III element in the photoactive layer exceeds the amount of group I element) by increasing the thickness of the region of the second thin film corresponding to the first part of the first electrode. In other words, the thickness of a region of the second thin film corresponding to the first part of the first electrode is larger than that of a region of the second thin film corresponding to the part of the first electrode having lower resistivity than the average resistivity of the first electrode by at most 5 percent.

At the same time, the thickness of the region of the first thin film corresponding to the first part of the first electrode is smaller than that of the region of the first thin film corresponding to the part of the first electrode having lower resistivity than the average resistivity of the first electrode by at most 5 percent.

In the embodiments where the resistivity of the first part of the first electrode is lower than the average resistivity of the first electrode by at least 5 percent, the thickness of the region of the first thin film corresponding to the first part is larger than that of the region of the first thin film corresponding to the part of the first electrode having lower resistivity than the average resistivity of the first electrode by at most 5 percent.

At the same time, the thickness of a region of the second thin film corresponding to the first part is smaller than that of a region of the second thin film corresponding to the part of the first electrode having lower resistivity than the average resistivity of the first electrode by at most 5 percent.

The second thin film having regions of different thickness depending on each region's forming position relative to the first electrode may be formed by changing a deposition speed.

The thin films having different thicknesses may be formed by controlling the deposition speed because the deposition speed is increased by increasing magnetic flux densities as a distance between a target surface and a magnet is decreased, and is decreased by decreasing magnetic flux densities as the distance therebetween is decreased.

If a vaporization method is used to form the photoactive layer, a plurality of vaporization sources can be used, and the photoactive layer 140 having regions of different group I to group III element composition ratios according to the resistivity of the first electrode may be formed by varying composition ratios of the vaporizing sources depending on the forming positions.

Next, the formation of the photoactive layer 140 made of CIGS is completed during a heat treatment process in a gas atmosphere including group VI elements such as selenium (Se) or sulfur (S).

In some embodiments, a heat treatment process may be performed for about 30 to 120 minutes at about 400 to 600 °C.

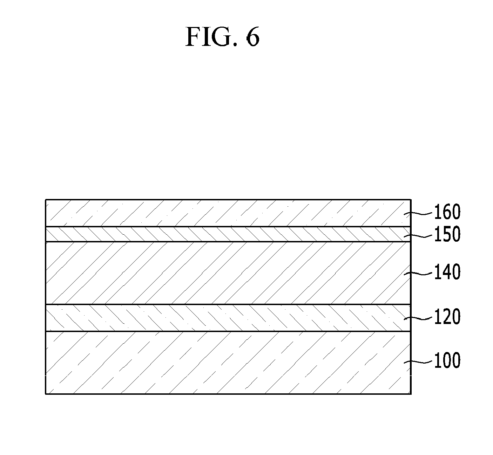

Next, as shown in FIG. 6, a buffer layer 150 is formed on the photoactive layer 140, and a second electrode 160 is formed on the buffer layer 150.

In one embodiment, the buffer layer 150 is made of an n-type semiconductor material, for example, CdS, ZnS, or InS.

The second electrode 160 may be made of ZnO, and may be formed by a direct current (DC) or radio frequency (RF) sputtering method using a ZnO target, or a reactive sputtering method using a Zn target, or organic metal chemical vapor deposition method.

In some embodiments, an anti-reflection layer 180 is formed on the second electrode 160.

The anti-reflection layer 180 may be made of $MgF_2$, and may be formed by an E-beam evaporation method.

Next, as shown in FIG. 1, a grid electrode 200 may be formed to be electrically connected to the second electrode 160, thus completing the solar cell.

The grid electrode 200 may be formed by a sputtering method, and may be made of aluminum or nickel.

As discussed, embodiments of the invention provide a solar cell comprising: a substrate; a first electrode over the substrate; a photoactive layer over the first electrode comprising group I and group III elements; and a second electrode over the photoactive layer, wherein the first electrode includes first and second parts having different resistivity, and group I to group III element composition ratios in regions of the photoactive layer respectively corresponding to the first and second parts are different from each other. A compound semiconductor including group I-III-VI elements may be used as the photoactive layer.

The resistivity of the first electrode may vary depending on a position on the substrate. In other words, the first and second parts may correspond to different regions on the substrate.

The photoactive layer may comprise a p-type CIS/CIGS based semiconductor may contain selenium (Se) or sulfur (S). For example, the photoactive layer 140 may be $Cu(In_{1-x},Ga_x)(Se_{1-x},S_x)$ as a group I-III-VI-based semiconductor compound, wherein $0 \leq x \leq 1$.

Embodiments of the invention can also provide a method of manufacturing a solar cell, the method comprising: forming a first electrode on a substrate; forming a photoactive layer comprising group I and group III elements on the first electrode; and forming a second electrode on the photoactive layer, wherein the group I to group III element composition ratio of the photoactive layer varies according to the resistivity of the first electrode.

The method can comprise determining the resistivity of the first electrode in different regions of the first electrode. This could be done by reference to the relative positions of said regions on the substrate. The resistivity can be estimated based on the previous measurements.

While this invention has been described in connection with what are presently considered to be practical exemplary embodiments, it is to be understood that the invention is not limited to the disclosed embodiments, but, on the contrary, is intended to cover various modifications and equivalent arrangements included within the scope of the appended claims.

**Claims**

1. A solar cell comprising:

   a substrate;
   a first electrode over the substrate;
   a photoactive layer over the first electrode comprising group I and group III elements; and
   a second electrode over the photoactive layer, wherein
   the first electrode includes first and second parts having different resistivity, and
   group I to group III element composition ratios in regions of the photoactive layer respectively corresponding to the first and second parts are different from each other.

2. The solar cell of claim 1, wherein the resistivity of the first part is higher or lower than the average resistivity of the first electrode.

3. The solar cell of claim 2, wherein when the resistivity of the first part is higher than the average resistivity of the first electrode, the group I to group III element composition ratio in regions of the photoactive layer corresponding to the first part is smaller than the average group I to group III element composition ratio of the photoactive layer, and when resistivity of the first part is lower than the average resistivity of the first electrode, the group I to group III element composition ratio in regions of the photoactive layer corresponding to the first part is larger than the average group I to group III element composition ratio of the photoactive layer.

4. The solar cell of claim 3, wherein the resistivity of the first part is higher than the average resistivity of the first electrode by at least 5 percent, and the group I to group III element composition ratio in regions of the photoactive layer corresponding to the first part is smaller than the average group I to group III element composition ratio of the photoactive layer by at least 0.01.

5. The solar cell of claim 3 or 4, wherein the difference between the resistivity of the second part and the average resistivity of the first electrode is less than 5 percent.

6. The solar cell of claim 3, wherein the resistivity of the first part is lower than the average resistivity of the first electrode by at least 5 percent, and the group I to group III element composition ratio in regions of the photoactive layer corresponding to the first part is larger than the average group I to group III element composition ratio of the photoactive layer by at least 0.01;
   optionally wherein the difference between the resistivity of the second part and the average resistivity of the first electrode is less than 5 percent.

7. The solar cell of any one of the preceding claims, wherein the group I to group III element composition ratio Y satisfies the following Equation 1:

$$\text{Equation 1}$$

$$Y = -0.0104X + 1.1226$$

   wherein X is the resistivity of the first electrode.

8. The solar cell of any one of the preceding claims, wherein the group I element is copper (Cu), silver (Ag), or gold (Au), and the group III element is indium (In) or gallium (Ga) and/or wherein the first electrode comprises molybdenum (Mo).

9. A method of manufacturing a solar cell, the method comprising:

   forming a first electrode on a substrate;
   forming a photoactive layer comprising group I and group III elements on the first electrode; and
   forming a second electrode on the photoactive layer, wherein the group I to group III element composition ratio of the photoactive layer varies according to the resistivity of the first electrode.

10. The method of claim 9, wherein the first electrode comprises a first part having higher resistivity than the average resistivity of the first electrode by at least 5 percent, and the group I to group III element composition ratio in regions of the photoactive layer corresponding to the first part is smaller than the average group I to group III element composition ratio of the photoactive layer by at least 0.01.

11. The method of claim 9, wherein the first electrode comprises a first part having lower resistivity than the average resistivity of the first electrode by at least 5 percent, and the group I to group III element composition ratio in regions of the photoactive layer corresponding to the first part is larger than the average group I to group III element composition ratio of the photoactive layer by at least 0.01.

12. The method of any one of claims 9 to 11, wherein the group I to group III element composition ratio Y satisfies the following Equation 1:

$$\text{Equation 1}$$

$$Y = -0.0104X + 1.1226$$

wherein X is the resistivity of the first electrode.

13. The method of any one of claims 9 to 12, wherein the photoactive layer is formed by a sputtering method or an evaporation method.

14. The method of claim 10, wherein the photoactive layer comprises a first thin film comprising group I and III elements and a second thin film comprising a group III element, wherein when the first part of the first electrode has higher resistivity than the average resistivity of the first electrode by at least 5 percent, the thickness of a region of the first thin film corresponding to the first part is smaller than that of a region of the first thin film corresponding to a part of the first electrode having lower resistivity than the average resistivity of the first electrode by at most 5 percent, and the thickness of a region of the second thin film corresponding to the first part is larger than that of a region of the second thin film corresponding to the part of the first electrode having lower resistivity than the average resistivity of the first electrode by at most 5 percent;
optionally wherein the group element I is copper (Cu), silver (Ag), or gold (Au), and the group III element is indium (In) or gallium (Ga).

15. The method of claim 11, wherein the photoactive layer comprises a first thin film comprising group I and III elements and a second thin film comprising a group III element, wherein when the first part of the first electrode has lower resistivity than the average resistivity of the first electrode by at least 5 percent, the thickness of a region of the first thin film corresponding to the first part is larger than that of a region of the first thin film corresponding to a part of the first electrode having lower resistivity than the average resistivity of the first electrode by at most 5 percent, and the thickness of a region of the second thin film corresponding to the first part is smaller than that of a region of the second thin film corresponding to the part of the first electrode having lower resistivity than the average resistivity of the first electrode by at most 5 percent;
optionally wherein the group I element is copper (Cu), silver (Ag), or gold (Au), and the group III element may be indium (In) or gallium (Ga).

FIG. 1

# FIG. 2

### (Cu/(In+Ga)
### COMPOSITION RATIO AND EFFICIENCY

CONVERSION
EFFICIENCY (%)

Mo RESISTIVITY

o 20.5    □ 23.4    △ 25.3

Cu/(In+Ga)
COMPOSITION RATIO

# FIG. 3

### Mo RESISTIVITY AND
### OPTIMAL COMPOSITION RATIO

(Cu/(In+Ga)
OPTIMAL COMPOSITION RATIO

Mo RESISTIVITY (μΩcm)

FIG. 4

FIG. 5

140

120

100

FIG. 6